# EUROPEAN PATENT APPLICATION

(11) **EP 4 730 917 A1**
(43) Date of publication of application: **22.04.2026**
(21) Application number: 25208773.9
(22) Date of filing: 15.10.2025
(51) Int. Cl.: H05B 45/10, H05B 47/115, H05B 47/175, F21V 23/04, G06F 3/01, H03K 17/94, F21Y 103/10, F21Y 115/10, F21V 11/12, F21K 9/272, F21S 4/28, F21S 2/00

(54) **LIGHTING DEVICE AND LIGHTING SYSTEM COMPRISING SAID LIGHTING DEVICE**

(30) Priority: 15.10.2024 IT 202400022902
(71) Applicant: L. & S. Italia S.p.A., 33070 Brugnera (PN) (IT)
(72) Inventor: Pasquali, Massimo, Maron di Brugnera (PN) (IT)
(74) Representative: Gregorj S.r.l.

(57) **Abstract**

Lighting device (1) comprising: a support structure (2) extending along a longitudinal direction (X); a first (10) and a second projecting wall (20) extending transversely from such support structure (2) and being mutually opposed; an LED lighting module positioned in the support structure (2); a first detection unit (31) placed at the first projecting wall (10); a second detection unit (32) placed at the second projecting wall (20). The detection units (31, 32) are oriented opposite each other and define a detection zone (J) between said projecting walls (10, 20) to detect an object (40) interposed between said projecting walls. The first detection unit (31) provides first input data to a main control unit and the second detection unit (32) provides second input data to the main control unit, so that said main control unit, based on said input data, provides command data to the LED lighting module. The first input data represent a distance between the object (40) and the first detection unit (31) and the second input data represent a distance between the object (40) and the second detection unit (32).

## Description

The present invention concerns a lighting device and a lighting system comprising such a lighting device.

In particular, the present invention relates to a gesture-controlled lighting device for activating and managing the light emitted by the lighting device.

Hereafter, the lighting device may also be called a "device" and the lighting system comprising this lighting device may also be called a "system", for simplicity's sake. In the context of the present invention, the expressions "supplying electricity", "electrifying", "energizing", "passing current", "powering", etc. are used synonymously.

In particular, the present invention relates to a gesture-controlled lighting device for activating and regulating the light emitted by the lighting device.

In the current state of the art, gesture-based control systems are known to be used for the activation and regulation of lighting devices. Such systems allow the user to activate and regulate the lighting device without the need for physical contact, using only hand movements or other gestures. However, the known solutions have several drawbacks.

One of the main problems encountered in known devices is related to the inaccuracy of gesture detection, due to the poor accuracy of the motion detection sensor. This results in the lighting device not being activated or regulated correctly or in time.

Moreover, a further disadvantage of current solutions lies in the difficulty of maintenance. Detection units, often located in hard-to-access areas, require complex procedures for their replacement or repair, increasing costs and maintenance time for the lighting device.

The problem underlying the present invention is that of providing a lighting device and lighting system comprising the same, which are structurally and functionally designed to overcome, at least in part, one or more of the drawbacks complained about above with reference to the cited known art.

In particular, it is an aim of the present invention to provide a lighting device and related system, in which maintenance operations are particularly simplified. Another aim of the present invention is to provide a lighting device and a related system, the production of which is economical and easily realisable, allowing simplification of production processes and a reduction in costs.

A further aim of the present invention is to provide a lighting device and related system, in which gesture control is particularly precise and reliable.

Another aim of the present invention is to provide a lighting system characterised by a modular structure that allows considerable flexibility in operation.

A further aim of the present invention is to provide a lighting device and related system, in which the arrangement of electrical cables is particularly orderly.

The above problem and aims are at least partly solved by the present invention by means of a lighting device comprising one or more of the features expressed in the following claims and a lighting system comprising such a lighting device.

In a first aspect thereof, the present invention relates to a lighting device comprising: a support structure extending along a longitudinal direction; a first and a second projecting wall extending transversely from such support structure and mutually opposed; an LED lighting module positioned in the support structure; a first detection unit placed at the first projecting wall; a second detection unit placed at the second projecting wall. Said detection units are oriented opposite each other and define a detection zone between said projecting walls to detect an object interposed between said projecting walls. The first detection unit provides first input data to a main control unit and the second detection unit provides second input data to the main control unit, so that said main control unit, based on said input data, provides command data to the LED lighting module. The first input data represent a distance between the object and the first detection unit and the second input data represent a distance between the object and the second detection unit. Thanks to the above-mentioned features, it is possible to obtain a lighting device capable of detecting the presence of the object in a particularly reliable and precise manner, as feedback on its position in the detection zone is provided by both detection units, which are placed opposite each other, thus providing respective feedback to the main control unit on the position of this object, both with respect to the first and second detection unit. Furthermore, since the detection units are placed on respective walls projecting from the support structure, they are easily accessible, simplifying any maintenance operations.

In a second aspect thereof, the present invention relates to a lighting system comprising the lighting device according to the invention, a driver platform and a control module, said driver platform being configured to power the control module, such control module comprising the main control unit and being configured to supply power to the detection units and the LED lighting module, to receive first and second input data from the detection units and provide them to the main control unit, and to provide command data from the main control unit to the LED lighting module.

Thanks to the modular configuration of the system, different modules can be linked together according to specific requirements, allowing the system to be adapted to different operating conditions. This modularity guarantees not only greater versatility in use, but also the possibility to expand or modify the system quickly and easily, without compromising its overall efficiency.

In at least one of the aforesaid aspects, the present invention may have one or more of the characteristics described below.

"Object" means any physical entity detectable by the first and/or second detection unit, including but not limited to a hand or other parts of the human body, as well as any other object capable of reflecting or interrupting a signal generated by the first and/or second detection unit. This definition can also be applied to the "first object" and the "second object", which will be described below.

Preferably, the detection units provide input data to the main control unit if they detect at least one object in the detection zone. Preferably, if the detection units do not detect at least one object in the detection zone, they do not provide input data to the main control unit.

Preferably, the first input data represent the distance along the longitudinal direction between the object and the first detection unit

Preferably, the second input data represent the distance along the longitudinal direction between the object and the second detection unit.

Preferably, the LED lighting module comprises a plurality of LED units.

Preferably, the LED lighting module is linear and extends along the longitudinal direction of the support structure. Preferably, the LED lighting module comprises a plurality of LED strips. Preferably, each LED strip comprises a plurality of LED units. Preferably, each LED strip comprises a microprocessor configured to control the individual LED units of that strip based on command data received from the main control unit. Preferably, each LED strip has a length comprised between 25cm and 35cm, even more preferably around 30cm.

Preferably, the command data supplied to the LED lighting module from the main control unit comprise a switch-on, switch-off, dimming, portioning, movement, extension, colour command etc.

"Switch-on command" means the switching on of all the LED units in the LED lighting module.

"Switch-off command" means the switching off of all the LED units in the LED lighting module.

"Dimming command" refers to the regulation of the light intensity emitted by the LED units of the LED lighting module.

"Portioning command" means the selective switching on of a portion, also called the "switch-on portion", of the LED lighting module, in which only a portion of the LED units that make up the module are switched on. If the LED lighting switch-on module is linear, this switch-on portion can be called the "switch-on segment".

"Movement command" means the translation of the switch-on portion along the longitudinal direction. This movement is a visual effect due to the simultaneous switching on and off of the LED units, to simulate the movement of the switch-on portion. In particular, the LED units in the forward direction are progressively switched on, while at the same time the LED units in the opposite direction are progressively switched off, creating the impression that the switch-on portion is moving along the longitudinal direction.

"Extension command" is defined as the variation of the extension of the switch-on portion along the longitudinal direction. This change can be a narrowing, resulting in LED units being switched off, or a widening, resulting in LED units being switched on.

"Colour command" refers to the change in the colour of the light emitted by the LED unit.

Preferably, the main control unit comprises a memory in which information is stored as to which command data is to be delivered by the control unit depending on the first and second input data received.

Preferably, the first and second projecting walls project transversely from the support structure so that they are mutually opposed and face each other. Preferably, the first and second projecting walls extend along a transverse direction. Preferably, the longitudinal and transverse directions form an angle comprised between 30° and 60°, even more preferably they are essentially perpendicular to each other. Preferably, the first and second projecting walls are essentially parallel to each other.

In some embodiments, the first and second projecting walls are directly connected to the support structure.

Preferably, the support structure is made of metal material, e.g. aluminium. Preferably, the support structure is shaped like an extrudate, i.e. it is obtained by extrusion moulding. In alternative embodiments, the support structure can be made of polymer material.

Preferably, the support structure has a dimension along the longitudinal direction comprised between 0.25m and 5m. Preferably, the LED lighting module has a dimension along the longitudinal direction substantially equal to that of the support structure.

Preferably, the lighting device is configured to be connectable to an undercabinet of a piece of furniture. Preferably, the support structure can be connected to the undercabinet via a threaded connection.

Preferably, the lighting device is controlled by a control system comprising the first and second detection units, the main control unit and LED lighting module. Preferably, the control system comprises a communication protocol that provides a communication language between the main control unit, the detection units and the LED lighting module.

Preferably, the control system comprises a bus communication system through which first and second input data are communicated from the detection units to the main control unit, and through which command data are communicated from the main control unit to the LED lighting module.

Therefore, "logical" information, i.e. first and second input data and command data, are preferably communicated via a bus communication system. Preferably, the bus communication system has a parallel configuration.

Preferably, the communication protocol is of the addressable type. "Addressable" refers to a communication protocol that allows each LED unit or groups of LED units on an LED strip to be individually controlled by assigning each (unit or group) a unique identifier. This makes it possible to customise colours, brightness and effects precisely for individual LED units or groups of LED units in the strip. The applicant found that it can be particularly advantageous to use an addressable communication protocol to control groups consisting of a limited number of LED units, e.g. four LED units, in order to achieve particularly precise portioning of the LED lighting module, while at the same time reducing costs and simplifying control management.

Preferably, the driver platform comprises: a power supply socket, to connect said driver platform to a power supply network; a connection socket, to which the control module can be connected; a power supply unit, which receives electrical energy from the power supply socket and implements an electrical energy transformation protocol, to regulate the voltage of said energy by supplying it to the connection socket. Preferably, said power transformation protocol is configured to transform the input voltage from the mains into an output voltage from the connection socket, with a certain output voltage value to power the control module. Preferably, this determined output voltage of the connection socket is about 24V.

An embodiment of such a driver platform is described in international patent application number WO2020234798A1. That patent application also describes auxiliary modules that can be connected to said driver platform. The control module of the system according to the invention is a type of such auxiliary module that can be connected to the driver platform.

Preferably, the control module comprises a printed circuit board on which the main control unit, a control driver and connectors are mounted. Preferably, the connectors are connected by wiring to the sensor units and the LED lighting module. Preferably, the control driver is configured to transform the input voltage received from the driver platform into an output voltage at the connectors, so that these connectors have a certain output voltage value to power the detection units and the LED lighting module. Preferably, this certain voltage output value of the connectors is around 12V.

Preferably, the control module is connected to the lighting device via a pair of cables, each of which contains one pair of parallel wires (clock and date) of the bus communication system and one pair of wires (positive and negative) for supplying power to the detection units and the LED lighting module. This results in a reduced footprint and wiring complexity, which facilitates the installation and management of the system.

In alternative embodiments, the lighting device itself comprises: the main control unit; the power supply socket, to connect the lighting device to the power supply network; a power supply unit, which receives electricity from the power supply socket and implements the electricity transformation protocol; the control driver; and connectors connected by wiring to the detection units and the LED lighting module. The power supply unit can be internal or external.

In a preferred embodiment, the lighting device comprises a first and a second transverse element, each comprising a connection portion, the support structure being interposed between the first and the second transverse element and connected to respective connection portions of said first and second transverse element, wherein the first transverse element comprises the first projecting wall and the second transverse element comprises the second projecting wall.

Thanks to this, the detection units are placed on opposite ends of the support structure and are therefore even more easily accessible for maintenance operations. Moreover, in this way, the detection zone extends longitudinally along the entire support structure.

Preferably, each transverse element comprises a removable cover. Preferably, the cover leaves one sensor of the respective sensor unit uncovered. Thanks to the cover, the detection unit can be easily accessed in the event of malfunctioning. Preferably, the first and second transverse elements extend along the transverse direction.

Preferably, the first and second transverse elements are made of polymer material, e.g. polycarbonate.

Preferably, each transverse element comprises connection elements configured to be connected to respective ends of the support structure. Preferably, each transverse element is connected to the support structure via threaded connections. According to a preferred embodiment, the lighting device comprises a cover profile connected to the support structure, configured to define a housing in which the LED lighting module is positioned, said cover profile comprising a transparent portion delimiting said housing.

This enables efficient heat dissipation, protection from damage, and uniform light distribution.

Preferably, the LED units are oriented towards the transparent portion. In this, the light emitted by these LED units is projected directly through the transparent portion, ensuring uniform and optimal light distribution.

Preferably, the cover profile is made of polymer material, e.g. polycarbonate.

According to a preferred embodiment, the cover profile comprises an opaque portion and is connected to the support structure in such a way as to define a light guide positioned between said support structure and said opaque portion. Light from the LED lighting module is visible through the light guide.

The light guide shields the light emitted by the LED lighting module, making it possible to reduce eye fatigue and, at the same time, check the status of the LED lighting module. The light guide captures the light emitted by the LED lighting module and projects it onto the edge of the profile, creating a light blade that allows the user to check the switch-on status, operating mode, etc. of the LED lighting module. This is particularly useful when there are portioning, movement and extension commands, as the user is able to have clear visual feedback through this light guide. The opaque portion prevents direct glare from the LED lighting module and precisely delimits the area illuminated by the light guide.

Preferably, the light guide extends along the longitudinal direction.

Preferably, the cover profile is produced by an extrusion process. In a preferred embodiment, the profile is made by a co-extrusion process, in which a transparent polymer material (e.g. polycarbonate) is used in the same mould to make the transparent portion and an opaque polymer material (e.g. polycarbonate) is used to make the opaque portion. This means the complete cover profile can be obtained downstream of a single moulding step, optimising efficiency and production costs. According to a preferred embodiment, each detection unit comprises a printed circuit board on which a microprocessor and an infrared sensor are mounted. This allows for non-contact interaction with an immediate and precise response, while maintaining high reliability in different ambient light conditions.

Preferably, the infrared sensor is of the active type. Hereafter, the active type infrared sensor may also be called "IR sensor" for simplicity.

Thanks to the IR sensor, high detection accuracy is achieved.

Preferably, the two IR sensors are mutually opposed and oriented opposite each other. Preferably, the two IR sensors are aligned along the longitudinal direction. Preferably, each IR sensor comprises an emitting diode and a photodiode. The emitting diode emits an infrared light beam and the photodiode detects the infrared light beam reflected by the object. The presence or movement of the object can be detected when the infrared light beam emitted by the emitting diode is reflected back to the photodiode. The closer an object is to the photodiode, the greater the amount of infrared light reflected by that object onto that photodiode. Preferably, the microprocessor of each detector unit, based on the amount of infrared light reflected on the respective photodiode, calculates the distance of the object from that photodiode. If, for example, the photodiode receives a large amount of infrared light, the microprocessor calculates that the object is close to the photodiode, and vice versa.

Since there are two IR sensors, the object in the detection zone reflects infrared light back to each photodiode, and each microprocessor processes information about the object's distance from the first and second detection units, based on the reflected infrared light. This provides double feedback that allows the position of the object to be identified particularly precisely.

Preferably, the first input data are provided by the microprocessor of the first detection unit to the control unit.

Preferably, the second input data are provided by the microprocessor of the second detection unit to the control unit.

Preferably, the detectable object of the detection units is the hand of a user, which can make a gesture in the detection zone. This gesture may, for example, be a movement of the hand along the longitudinal direction, to or from the first or second detection unit (swipe), the static interposition of two hands between the two detection units, the static interposition of one hand between the two detection units and the subsequent movement of that hand along towards the first or second detection unit, etc. Preferably, the main control unit is configured to activate the LED lighting module according to the detected gesture. For this reason, the lighting device can be called "gesture-controlled", i.e. the lighting device can be controlled by detecting gestures made by a user, for the activation and adjustment of the light emitted by that lighting device.

The use of two mutually opposing IR sensors facing each other allows additional information to be obtained that is not accessible using a single sensor. In particular, the direction of the movement of the gesture can be deduced from the sensor that first detects the interruption of the infrared light beam, making it possible to determine both the start and end point of the hand movement. Furthermore, the speed of the gesture can be estimated by measuring the time it takes for the moving hand to pass between the two sensors. This configuration enables two-directional detection, distinguishing gestures according to their direction, e.g. from left to right, or vice versa. Finally, the presence of two infrared beams allows more complex interactions to be implemented, such as swipe gestures, double swipes, or adjustments of parameters, such as brightness, depending for instance on the speed or direction of movement.

In accordance with a preferred embodiment, the command data consist of the command to switch on or switch off, in the event that there is a change in the first and second input data due to a movement of the object in the detection zone along the longitudinal direction.

If the object is a user's hand, this reduces the risk of accidental switching on, as an intentional, directional movement (swipe) is recognised to switch on the lighting device, rather than a simple positioning of the hand between the sensors. It also allows for more precise interaction control, avoiding unintentional activations due to random movements or temporary obstacles.

Preferably, the change in the first input data represents a change in the distance between the object and the first detection unit. If the first detection unit comprises the IR sensor, the distance variation is proportional to the variation in infrared radiation intensity detected by that IR sensor. In particular, if the object moves into the detection zone approaching the IR sensor, i.e. if there is a decrease in the distance between the object and the IR sensor, that IR sensor detects an increase in the infrared light reflected by the object towards that IR sensor; if the object moves into the detection zone moving away from the sensor, i.e. if there is an increase in the distance between the object and the IR sensor, that IR sensor detects a decrease in the infrared light reflected by the object towards that IR sensor.

Preferably, the change in the second input data represents a change in the distance between the object and the second detection unit. If the second detection unit comprises the IR sensor, the distance variation is proportional to the variation in infrared radiation intensity detected by that IR sensor. In particular, if the object moves into the detection zone approaching the IR sensor, i.e. if there is a decrease in the distance between the object and the IR sensor, that IR sensor detects an increase in the infrared light reflected by the object towards that IR sensor; if the object moves into the detection zone moving away from the sensor, i.e. if there is an increase in the distance between the object and the IR sensor, that IR sensor detects a decrease in the infrared light reflected by the object towards that IR sensor.

Preferably, when an object is moved into the detection zone, both the first and second detection units detect the change in the distance of the object with respect to the first and second detection units.

According to a preferred embodiment, the command data consist of the dimming command, where, for a predetermined time interval, the first and second input data remain constant due to the static presence of the object in the detection zone, and, after this time interval, there is a change in the first and second input data due to a movement of the object in the detection zone along the longitudinal direction.

If the object is a user's hand, this sequence of movements allows the desired effect to be achieved with greater reliability and precision.

Preferably, the first input data remain constant when the distance between the object and the first detection unit remains constant.

Preferably, the second input data remain constant when the distance between the object and the second detection unit remains constant.

Preferably, this variation of first and second data after the predetermined time interval is due to a movement of the object towards the first or second detection unit.

Preferably, the predetermined time interval is comprised between 2 and 5 seconds. According to a preferred embodiment, the command data consist of portioning command to turn on a switch-on portion of the LED lighting module, in the event that the detection units detect a first and a second object in the detection zone, the first input data representing a first distance between the first object and the first detection unit and the second input data representing a second distance between the second object and the second detection unit, such switch-on portion having an extension defined between a first end, at the first object, and a second end, at the second object.

This improves both the accuracy and reliability of the control, as the control units can simultaneously detect objects. This reduces the risk of erroneous or accidental detection and enables more precise recognition.

Preferably, the first input data represent the distance along the longitudinal direction between the first object and the first detection unit and the second input data represent the distance along the longitudinal direction between the second object and the second detection unit.

In a preferred embodiment, the first input data represent the distance along the longitudinal direction between the first object and the first detection unit and between the second object and the first detection unit, and the second input data represent the distance along the longitudinal direction between the first object and the second detection unit and between the second object and the second detection unit. This is the case, for example, when each detection unit comprises an IR sensor and enables particularly precise and reliable object position detection. Preferably, the first and second objects are the hands of a user, even more preferably, the first object is the user's right hand and the second object is the user's left hand, or vice versa.

Preferably, the main control unit, after receiving the first and second input data, and thus the distance between the first object and the first detection unit and the distance between the second object and the second detection unit, is able to calculate the co-ordinates of the first and second ends of the switch-on portion, and provide the portioning command to the LED switch-on module, which switches on the LED units between said ends.

Preferably, the accuracy with which the LED main control unit is able to detect these ends depends on the communication protocol, whereby the minimum number of LED units that can be controlled simultaneously changes: the lower this number, the higher the accuracy. For example, a minimum of four LED units can be controlled at a time, which allows for particularly precise portioning of the LED lighting module.

Preferably, the switch-on portion extends along the longitudinal direction. Preferably, the switch-on portion is essentially linear (switch-on segment).

In accordance with a preferred embodiment, the command data consist of a movement command, in the event that:
- the first object is removed from the detection zone, the second object is placed in the detection zone between the first and second ends of the switch-on portion and thereafter there is a change in the first and second input data due to a movement of the second object in the detection zone along the longitudinal direction, or vice versa; or
- both the first and the second object are placed in the detection zone between the first and the second end and there is a variation in the first and second input data due to a movement of the first and second objects in the detection zone along the longitudinal direction so that a distance between these objects remains substantially constant during this movement.

"Or vice versa" means the case where the second object is removed from the detection zone and the first object is placed in the detection zone between the first and second ends of the switch-on portion and there is subsequently a change in the first and second input data due to a movement of the first object in the detection zone along the longitudinal direction.

This makes it possible to achieve intuitive interaction for a user, particularly if the objects are his or her hands, which can be adapted to different use requirements and environmental contexts.

Preferably, after receiving the change in the first and second input data, the main control unit is able to calculate new coordinates of the first and second end of the switch-on portion, and provide the movement command to the LED switch-on module, which switches on the LED units between these new end co-ordinates. Preferably, the main control unit is capable of progressively calculating this change in coordinates that occurs during the movement of the first and/or second object, creating the impression that the switch-on portion is moving along the longitudinal direction, progressively switching on the LED units in the forward direction and simultaneously progressively switching off the LED units in the opposite direction. Preferably, the main control unit calculates these new coordinates so that the extension of the switch-on portion remains constant before and after the movement.

"Extension of the switch-on portion" means the size of the switch-on portion defined between its two ends, preferably calculated along the longitudinal direction.

In accordance with a preferred embodiment, the command data consist of an extension command, in the event that the first input data remain constant due to the static presence in the detection zone of the first object at the first end of the switch-on portion and the second input data undergo a change due to a displacement in the detection zone of the second object from the second end of the switch-on portion along the longitudinal direction, so that the extension of the switch-on portion is modified by moving its second end as a result of said displacement of the second object, or vice versa.

"Or vice versa" means the case in which the second input data remain constant due to the static presence in the detection zone of the second object at the second end of the switch-on portion and the first data undergo a change due to a movement in the detection zone of the first object from the first end of the switch-on portion along the longitudinal direction, so that the extension of the switch-on portion is changed by moving its first end as a result of said movement of the first object.

This allows for intuitive interaction for a user, particularly if the objects are their hands, as they can adapt the extension of the switch-on portion with a simple hand movement.

Preferably, after receiving the change in the first or second input data due to the aforementioned movement, the main control unit is able to calculate the new co-ordinates of the first or second end of the switch-on portion, and provide the extension command to the LED switch-on module, which switches on the LED units between said new co-ordinates of such ends.

The characteristics and advantages of the invention will become clearer from the detailed description of an embodiment shown, by way of non-limiting example, with reference to the appended drawings wherein:
Figure 1 shows a perspective view of an embodiment of the lighting device according to the invention;
Figure 2 shows a schematic view of an example embodiment of the lighting system according to the invention;
Figures 3 and 4 show perspective views of the lighting device at the first projecting wall and the first detection unit;
Figures 5A and 5B show the first detection unit placed on the first projecting wall and the second detection unit placed on the second projecting wall, respectively;
Figure 6 shows a cross-section of the lighting device;
Figures 7A and 7B show examples of gestures for providing an on and off command, respectively;
Figures 8A-8C show examples of gestures for providing a dimming command;
Figure 9 shows an example of gestures for providing a portioning command;
Figure 10 shows an example of gestures for providing a movement command;
Figure 11 shows an example of gestures for providing an extension command.

In the examples in the figures, a lighting device is collectively referred to as 1 and a lighting system as 100, made in accordance with the present invention.

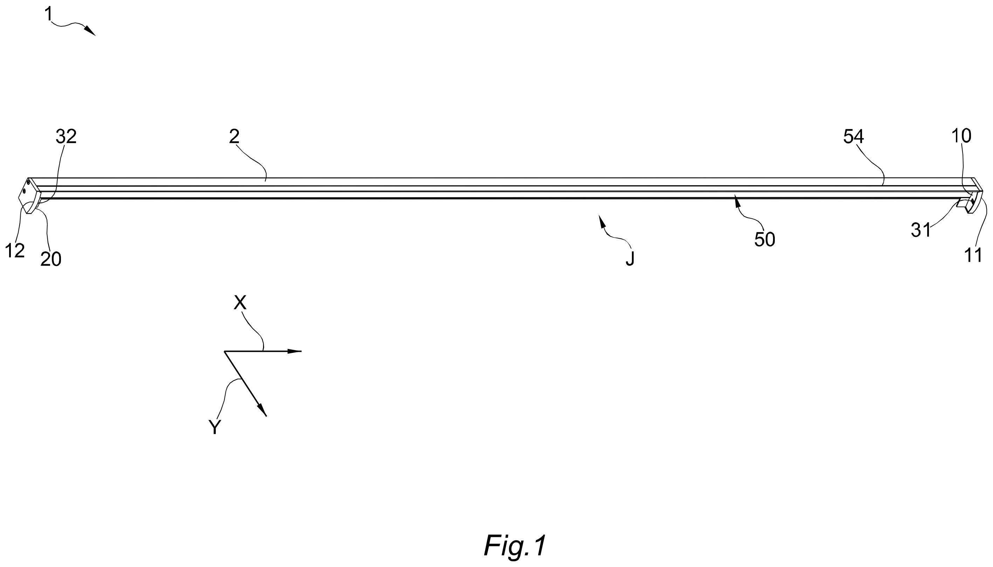

As can be seen in the example in Figure 1, the lighting device 1 comprises a support structure 2 extending along a longitudinal direction X; a first 10 and a second projecting wall 20 extending transversely from such support structure 2 and being mutually opposed; an LED lighting module positioned in the support structure 2; a first detection unit 31 positioned at the first projecting wall 10; a second detection unit 32 positioned at the second projecting wall 10.

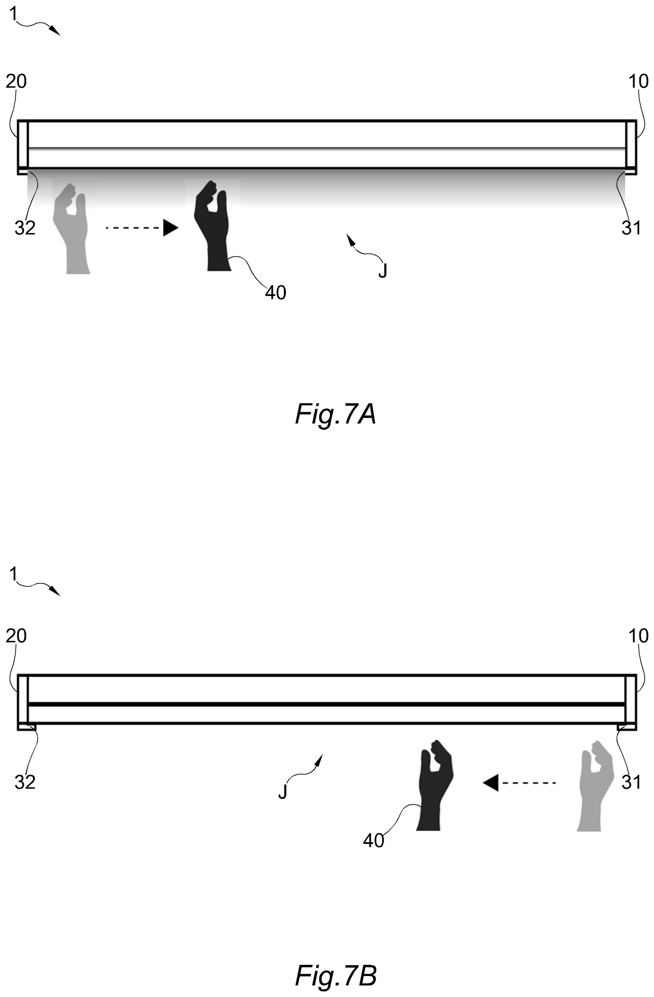

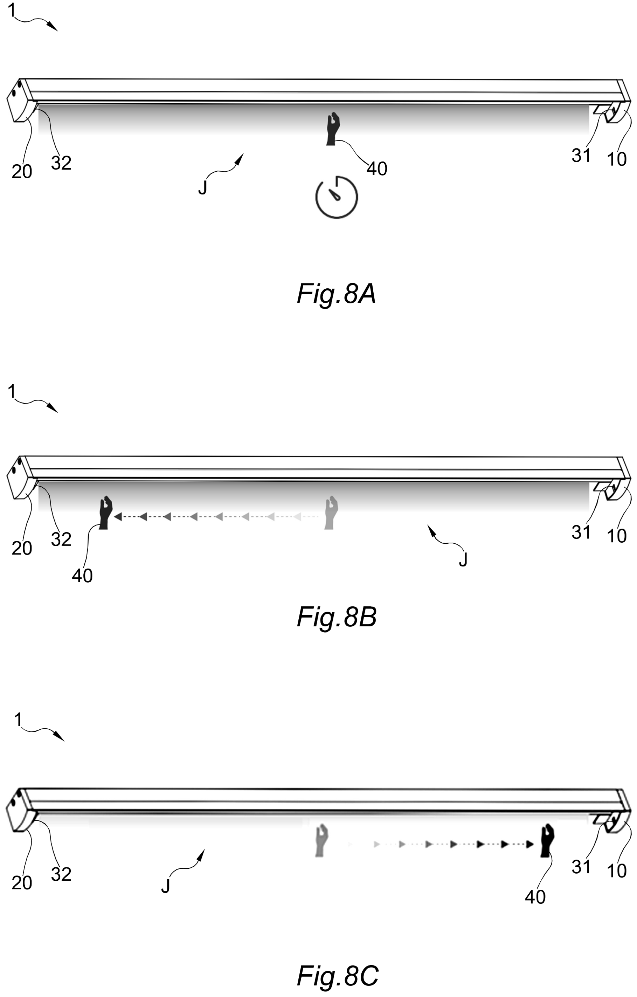

Said detection units 31, 32 are oriented opposite each other and define a detection zone J between said projecting walls 10, 20 to detect an object 40 interposed between said projecting walls 10, 20. Such an object 40 could for example be a user's hand, as shown in the examples in Figures 7A, 7B and 8A-8C.

The first detection unit 31 provides first input data to a main control unit and the second detection unit 32 provides second input data to the main control unit, so that said main control unit, based on said input data, provides command data to the LED lighting module. The first input data represent a distance between the object 40 and the first detection unit 31 and the second input data represent a distance between the object 40 and the second detection unit 32.

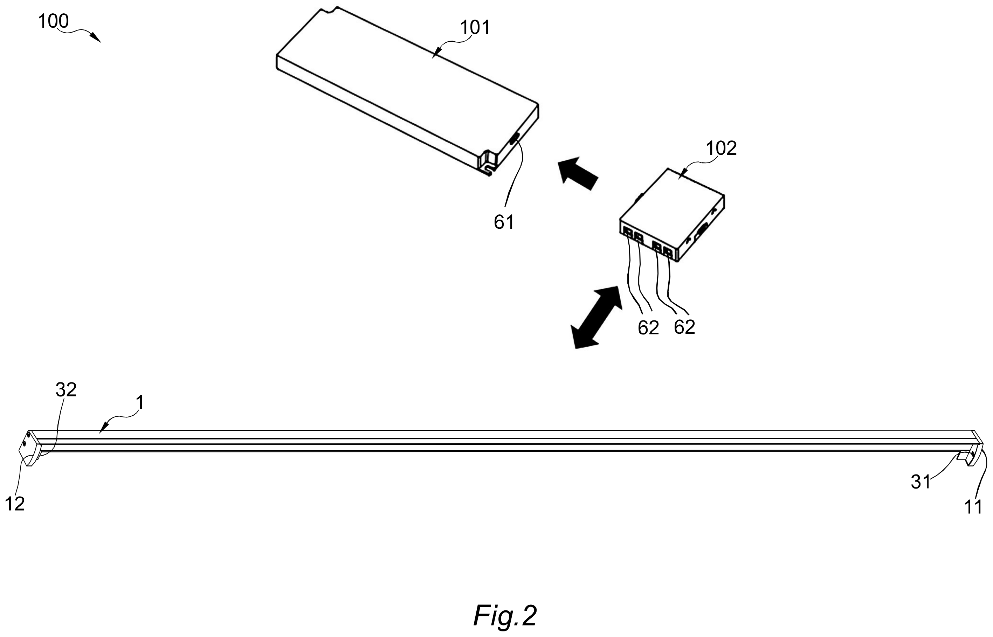

As shown in the example in Figure 2, the lighting system 100 comprises lighting device 1, a driver platform 101 and a control module 102. The driver platform 101 is configured to power the control module 102. The control module 102 comprises the main control unit and is configured to supply power to the detection units 31, 32 and the LED lighting module, to receive first and second input data from the detection units 31, 32 and provide them to the main control unit, and to provide command data from the main control unit to the LED lighting module.

The first 10 and the second projecting wall 20 project transversely from the support structure 2, so that they are mutually opposed and face each other. The first 10 and the second projecting wall 20 extend along a transverse direction Y. The longitudinal X and transverse Y directions are essentially perpendicular to each other. The first 10 and the second projecting wall 20 are essentially parallel to each other.

In some embodiments, the first 10 and the second projecting wall 20 are directly connected to the support structure 2.

Preferably, the lighting device 1 is controlled by a control system comprising the first 31 and second detection unit 32, the main control unit and LED lighting module. Preferably, the control system comprises a communication protocol that provides a communication language between the main control unit, the detection units 31, 32 and the LED lighting module. Preferably, the control system comprises a bus communication system through which first and second input data are communicated from the detection units 31, 32 to the main control unit, and through which command data are communicated from the main control unit to the LED lighting module. Preferably, the bus communication system has a parallel configuration.

Preferably, the driver platform 101 comprises: a power supply socket, to connect said driver platform to a power supply network; a connection socket 61, to which the control module 102 can be connected; a power supply unit, which receives electrical energy from the power supply socket and implements an electrical energy transformation protocol, to regulate the voltage of said energy by supplying it to the connection socket 61. Preferably, said power transformation protocol is configured to transform the input voltage from the mains into an output voltage from the connection socket 61, with a certain output voltage value to power the control module 102. Preferably, this determined output voltage of the connection socket 61 is about 24V.

Preferably, the control module 102 comprises a printed circuit board on which the main control unit, a control driver and connectors 62 are mounted. Preferably, the connectors 62 are connected by wiring to the sensor units 31, 32 and the LED lighting module. Preferably, the control driver is configured to transform the input voltage received from the driver platform 101 into an output voltage at the connectors 62, so that these connectors 62 have a given output voltage value to power the detection units 31, 32 and the LED lighting module. Preferably, this determined voltage output value of the connectors 62 is around 12V.

Preferably, the control module 102 is connected to the lighting device 1 via a pair of cables, each of which contains one pair of parallel wires (clock and date) of the bus communication system and one pair of wires (positive and negative) for supplying power to the detection units 31, 32 and the LED lighting module. Preferably, each cable terminates with a connector plug where these pairs of wires meet.

Preferably, the LED lighting module comprises a plurality of LED units. Preferably, the LED lighting module is linear and extends along the longitudinal direction X. Preferably, the LED lighting module comprises a plurality of LED strips. Preferably, each LED strip comprises a plurality of LED units.

The lighting device 1 comprises a first 11 and a second transverse element 12, each comprising a connection portion 13. The support structure 2 is interposed between the first 11 and second transverse element 12 and is connected to the respective connection portions 13 of said first 11 and second transverse element 12. The first transverse element 11 comprises the first projecting wall 10 and the second transverse element 12 comprises the second projecting wall 20. As a result, the detection units 31, 32 are placed at opposing ends of the support structure 2. The first 11 and the second transverse element 12 extend along the transverse direction Y.

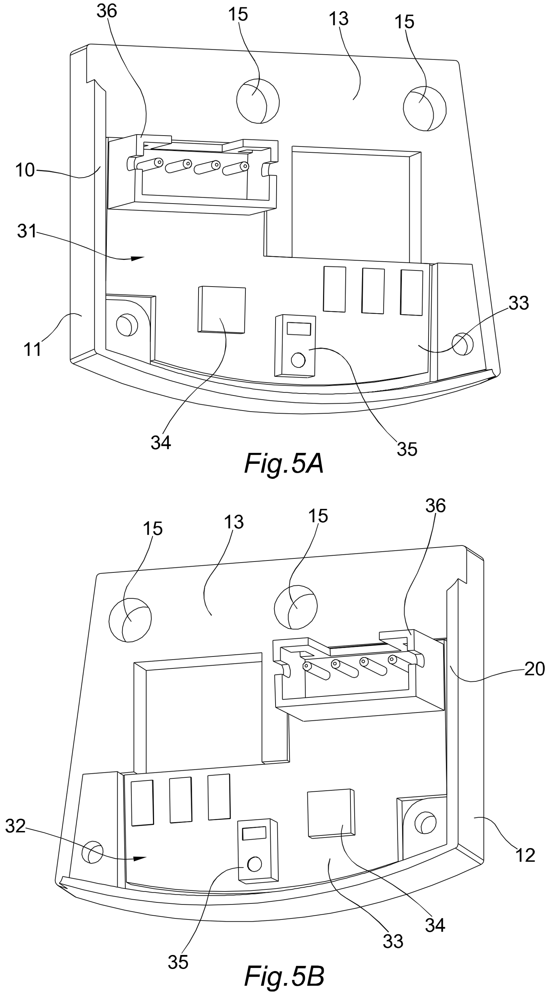

In the examples in Figures 5A and 5B it is shown that each transverse element 11, 12 comprises connecting elements 15 configured to be connected to respective ends of the support structure 2. Preferably, these connecting elements 15 are configured as openings. Preferably, each transverse element 11, 12 is connected to the support structure 2 via these openings through which threaded connections pass for the attachment of each transverse element 11, 12 to a respective end of the support structure 2.

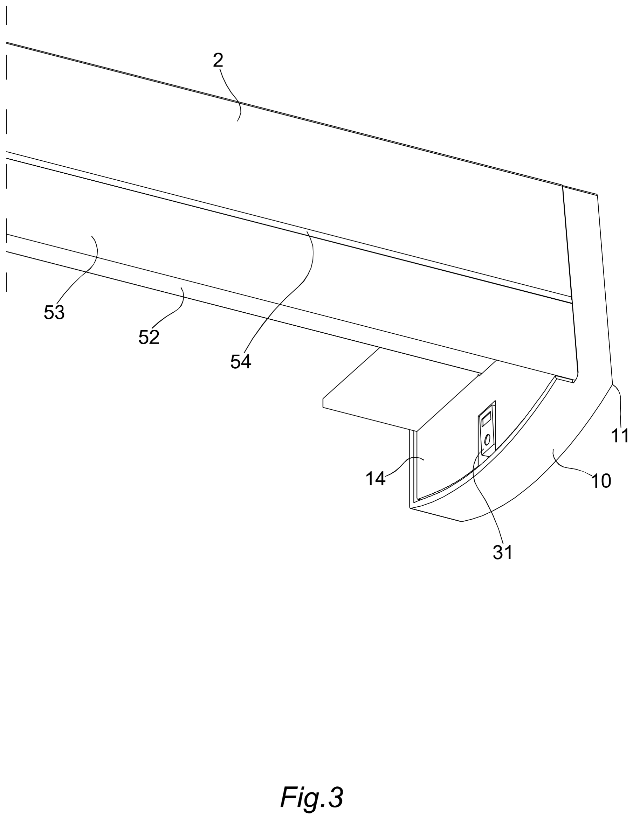

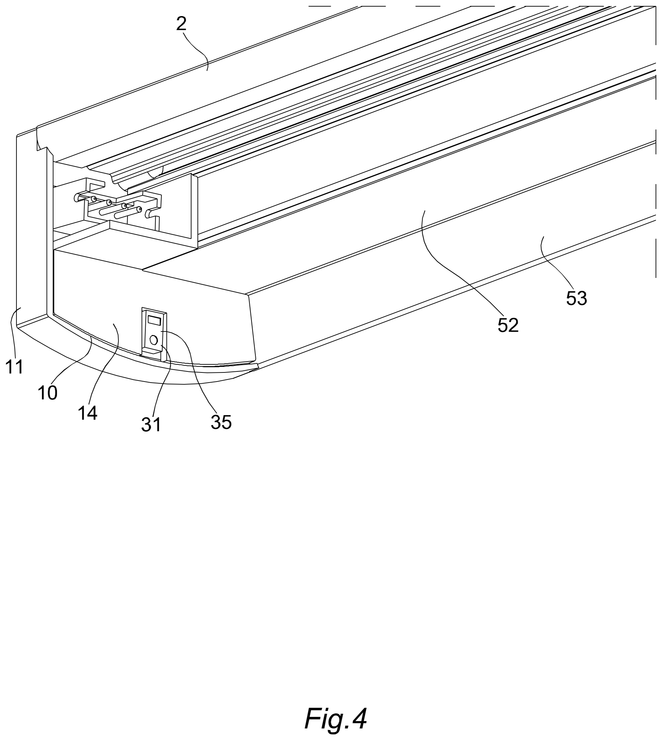

As shown in the examples in Figures 3 and 4, each transverse element 11, 12 comprises a removable lid 14. The lid 14 leaves one sensor 35 of the respective detection unit 31, 32 uncovered.

Each detection unit 31, 32 comprises a printed circuit board 33 on which a microprocessor 34 and sensor 35, preferably an active infrared type (IR sensor), are mounted. The printed circuit boards 33 can be seen in the examples in Figures 5A and 5B, where the lid 14 has been removed.

The two IR sensors 35 are mutually opposed, aligned along the longitudinal direction X and facing each other.

Each IR sensor 35 comprises an emitting diode and a photodiode. The emitting diode emits an infrared light beam and the photodiode detects the infrared light beam reflected by the object 40. The microprocessor 34 of each detection unit 31, 32, based on the amount of infrared light reflected by the object 40 on the respective photodiode, calculates the distance of the object 40 from that photodiode. Since there are two IR sensors 35, the object 40 present in the detection zone J reflects infrared light back to each photodiode and each microprocessor 34 processes information regarding the distance of the object 40 from the first 31 and second detection unit 32, based on the reflected infrared light. Preferably, the first input data is provided by the microprocessor 34 of the first detection unit 31 to the control unit and the second input data is provided by the microprocessor 34 of the second detection unit 32 to the control unit.

Preferably, each transverse element 11, 12 comprises a connector 36 configured to receive the connection plug described above with reference to the control module 102. Via the connector 36, the control module 102 supplies power to the printed circuit board 33 and the LED lighting module, and at the same time allows logic information to be exchanged between the main control unit, the first 31 and the second sensor unit 32 and the LED lighting module. Preferably, the connector 36 comprises four terminals. Preferably, each terminal can be connected to one of the wires in the cable that connects the control module 102 to the lighting device 1.

As can be seen from the examples in Figures 5A and 5B, the transverse elements 11, 12 preferably have a substantially similar configuration, with their respective elements arranged in a specular manner with respect to a plane of symmetry perpendicular to the longitudinal direction X.

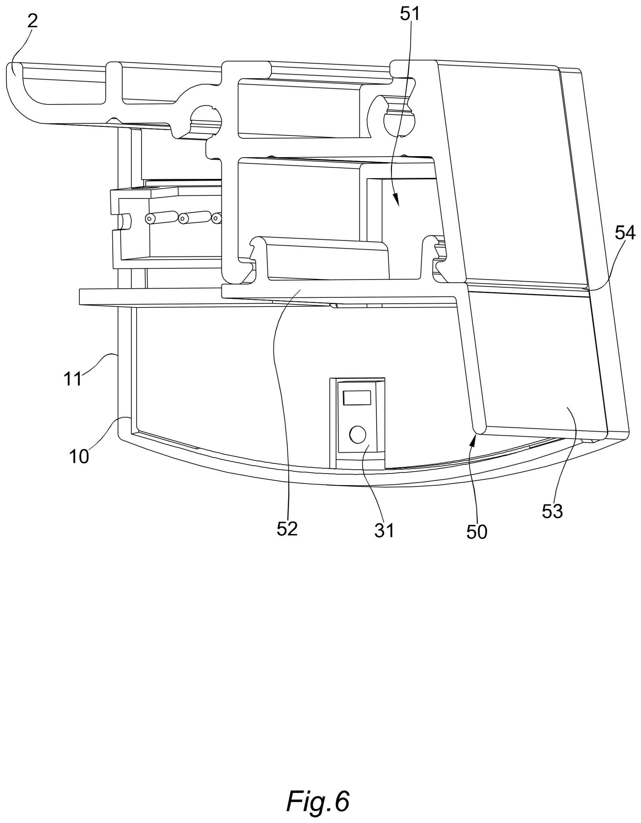

The lighting device 1 comprises a cover profile 50 connected to the support structure 2. As shown in the example in Figure 6, the cover profile 50 is configured to define a housing 51 in which the LED lighting module is positioned. The cover profile 50 comprises a transparent portion 52 that delimits said housing 51. Preferably, the LED units are oriented towards the transparent portion 52.

The cover profile 50 comprises an opaque portion 53 and is connected to the support structure 2 so as to define a light guide 54 between the support structure 2 and the opaque portion 53. Light from the LED lighting module is visible through the light guide 54. Preferably, the light guide 54 extends along the longitudinal direction X. Preferably, the light guide 54 is configured as a slot.

Preferably, the detectable object 40 of the detection units 31, 32 is the hand of a user, which can make a gesture in the detection zone J. The main control unit is configured to activate the LED lighting module according to the detected gesture. As shown in the examples in Figures 7A and 7B, the command data consist of the command to switch on or switch off, respectively, if there is a change in the first and second input data due to a movement of the object 40 in the detection zone J along the longitudinal direction X.

In the example of Figure 7A, the object 40, i.e., the hand, is initially brought close to the second detection unit 32 and subsequently moved towards the first detection unit 31 in the detection zone J along the longitudinal direction X. In this example, the command data consist of the command to switch on the LED lighting module.

In the example of Figure 7B, the object 40, i.e. the hand, is initially brought close to the first detection unit 31 and subsequently moved towards the second detection unit 32 in the detection zone J along the longitudinal direction X. In this example, the command data consist of the command to switch off the LED lighting module.

When the object 40 is moved into the detection zone J, both the first 31 and second detection unit 32 detect the change in the distance of the object 40 with respect to the first 31 and second detection unit 32.

As shown in the examples of Figures 8A-8C, the command data consist of the dimming command in the event that, for a predetermined time interval, the first and second input data remain constant due to the static presence of the object 40 in the detection zone J, and, after such time interval, there is a change in the first and second input data due to a movement of the object 40 in the detection zone J along the longitudinal direction X.

In the example in Figure 8A, the object 40 is shown statically placed in the detection zone J for the predetermined time interval. The first input data remain constant when the distance between the object 40 and the first detection unit 31 remains constant and the second input data remain constant when the distance between the object 40 and the second detection unit 32 remains constant. Preferably, the predetermined time interval is comprised between 2 and 5 seconds. In the example of Figure 8B, the variation of the first and second data is shown, due to a movement of the object 40 in the detection zone J along the longitudinal direction X towards the second detection unit 32, which in this case generates an increase in the light intensity generated by the LED lighting module.

In the example of Figure 8C, the variation of the first and second data is shown, due to a movement of the object 40 in the detection zone J along the longitudinal direction X towards the first detection unit 31, which in this case generates a decrease in the light intensity generated by the LED lighting module.

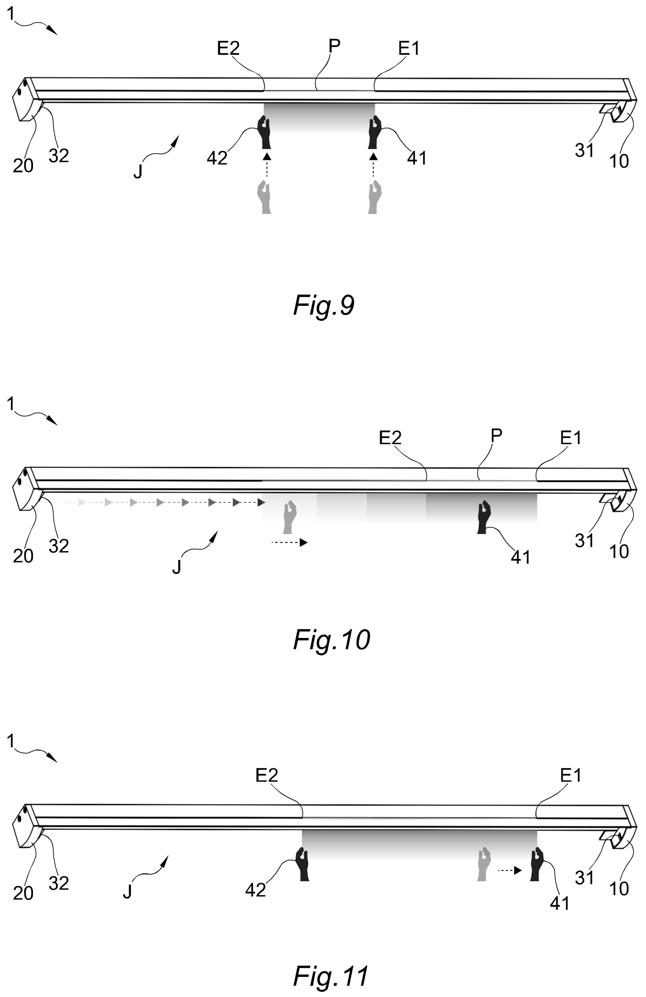

As shown in the example of Figure 9, the command data consist of a portioning command to switch on a lighting portion P of the LED lighting module, in the case where the detection units 31, 32 detect a first 41 and a second object 42 in the detection area J. In this case, the first input data represent a first distance between the first object 41 and the first detection unit 31 and the second input data represent a second distance between the second object 42 and the second detection unit 32. The switch-on portion P has a defined extension between a first end E1 and a second end E2. The first end E1 is at the first object 41 and the second end E2 is at the second object 42.

As shown in the example in Figure 9, the first 41 and the second object 42 are the hands of a user, specifically the first object 41 is the user's right hand and the second object 42 is the user's left hand.

The main control unit, after receiving the first and second input data, and thus information regarding the distance between the first object 41 and the first detection unit 31 and the distance between the second object 42 and the second detection unit 32, is able to calculate the coordinates of the first E1 and the second end E2 of the switch-on portion P, and to provide the portioning command to the LED switch-on module, which switches on the LED units between said ends E1, E2.

The switch-on portion P extends along the longitudinal direction X and is preferably linear (switch-on segment).

As shown in the example in Figure 9, the command data consist of a movement command in the event that the second object 42 is removed from the detection zone J and the first object 41 is placed in the detection zone J between the first E1 and the second E2 end of the switch-on portion P and subsequently there is a change in the first and second input data due to a movement of the first object 41 in the detection zone J along the longitudinal direction X.

The main control unit, after receiving the change in the first and second input data, is able to calculate new coordinates of the first E1 and second E2 ends of the switch-on portion P, and to provide the movement command to the LED switch-on module, which switches on the LED units between said new coordinates of these ends E1, E2. Preferably, the main control unit calculates these new coordinates so that the extension of the switch-on portion P remains constant before and after the movement.

In the example in Figure 9, it is shown that the second object 42 (the left hand) has been removed from the detection zone J and that the first object 41 (the right hand) is in the detection zone J interposed between the first E1 and the second E2 end of the switch-on portion P and that this first object 41 is progressively moved towards the first detection unit 31, resulting in the switch-on portion P being moved towards the first detection unit 31.

As shown in the example of Figure 10, the command data consist of an extension command, in the event that the second input data 42 remain constant due to the static presence in the detection zone J of the second object 42 at the second end E2 of the switch-on portion P and the first input data undergo a change due to a movement in the detection zone J of the first object 41 from the first end E1 of the switch-on portion P along the longitudinal direction X, so that the extension of the switch-on portion P is modified by moving its first end E1 as a result of said movement of the first object 41.

The main control unit, after receiving the change in input data due to the aforementioned movement, is able to calculate the new coordinates of the first end E1 of the switch-on portion P, and to provide the extension command to the LED switch-on module, which switches on the LED units between such new coordinates of such ends E1, E2.

In the example in Figure 10, it is shown that the second object 42 (the left hand) remains fixed in the detection zone J at the second end E2 of the switch-on portion P and that the first object 41 (the right hand) is moved into the detection zone J from the initial coordinate of the first end E1 of the switch-on portion P along the longitudinal direction X towards the first detection unit 31. In this way, the main control unit receives a change in the input data and gives the LED lighting module the command to extend the switch-on portion P, providing the new co-ordinates of the first end E1 of the switch-on portion P and increasing the extension of this switch-on portion P.

If two IR sensors 35 are present, such IR sensors 35 measure the amount of infrared light reflected by the first 41 and second object 42. The detection units 31, 32 provide the main control unit with input data that may be related to the intensity of the infrared light detected by the IR sensors 35 and, possibly, data related to the variation of this intensity over time. The intensity of the detected infrared light is inversely proportional to the distance of the objects 41, 42 from the IR sensors 35. The variation in time of this intensity occurs, for example, when the objects 41, 42 are moved within the detection zone J, e.g. when hands move while performing a gesture. In this case, the detection units 31, 32 provide time-varying input data, allowing the main control unit to detect changes in the amount of infrared light detected by the IR sensors 35 and to provide related command data to the LED lighting module.

In the examples shown in Figures 7A to 10, the objects 40, 41, 42 are represented schematically with a hand icon. In some of these figures, the hand icon is shown in grey, to represent the initial position of the object 40, 41, 42, and in black, to represent the final position of the object 40, 41, 42; in this case, arrows are shown to indicate the direction of movement of the object 40, 41, 42. Figure 8A shows the clock symbol to represent that the object 40 remains stationary in that position for the predetermined time interval.

## Claims

1. Lighting device (1) comprising:
• a support structure (2) extending along a longitudinal direction (X);
• a first (10) and a second projecting wall (20) extending transversely from this support structure (2) and being mutually opposed;
• an LED lighting module positioned in the support structure (2);
• a first detection unit (31) placed at the first projecting wall (10);
• a second detection unit (32) placed at the second projecting wall (20);
said detection units (31, 32) being oriented opposite each other and defining a detection zone (J) between said projecting walls (10, 20) to detect an object (40) interposed between said projecting walls,
the first detection unit (31) providing first input data to a main control unit and the second detection unit (32) providing second input data to the main control unit, so that said main control unit, based on said input data, provides command data to the LED lighting module,
wherein the first input data represent a distance between the object (40) and the first detection unit (31) and the second input data represent a distance between the object (40) and the second detection unit (32).

2. Lighting device (1) according to the preceding claim, comprising a first (11) and a second transverse element (12), each comprising a connection portion (13), the support structure (2) being interposed between the first (11) and the second transverse element (12) and connected to respective connection portions (13) of said first (11) and second transverse element (12), the first transverse element (11) comprising the first projecting wall (10) and the second transverse element (12) comprising the second projecting wall (20).

3. Lighting device (1) according to any one of the preceding claims, comprising a cover profile (50) connected to the support structure (2), configured to define a housing (51) in which the LED lighting module is positioned, said cover profile (50) comprising a transparent portion (52) delimiting said housing (51).

4. Lighting device (1) according to the preceding claim, wherein the cover profile (50) comprises an opaque portion (53) and is connected to the support structure so as to define a light guide (54), positioned between said support structure (2) and said opaque portion (53) and through which the light from the LED lighting module is visible.

5. Lighting device (1) according to any one of the preceding claims, wherein each detection unit (31, 32) comprises a printed circuit board (33) on which a microprocessor (34) and an infrared sensor (35), preferably of an active type, are mounted.

6. Lighting device (1) according to any one of the preceding claims, wherein the command data consist of an on or off command, in the event that there is a variation of the first and second input data due to a displacement of the object (40) in the detection zone (J) along the longitudinal direction (X).

7. Lighting device (1) according to any one of the preceding claims, wherein the command data comprise a dimming command, in the event that the first and second input data remain constant, due to the static presence of the object (40) in the detection zone (J) for a predetermined time interval, after which there is a change in the first and second input data, due to a displacement of the object (40) in the detection zone (J) along the longitudinal direction (X).

8. Lighting device (1) according to any one of the preceding claims, wherein the command data comprise a portioning command to turn on a switch-on portion (P) of the LED lighting module, in the event that the detection units (31, 32) detect a first (41) and a second object (42) in the detection zone (J), the first input data representing a first distance between the first object (41) and the first detection unit (31) and the second input data representing a second distance between the second object (42) and the second detection unit (32), such switch-on portion (P) having an extension defined between a first end (E1), at the first object (41), and a second end (E2), at the second object (42).

9. Lighting device (1) according to the preceding claim, wherein the command data consist of a movement command, in the event that:
• the first object (41) is removed from the detection zone (J), the second object (42) is placed in the detection zone (J) between the first (E1) and second (E2) ends of the switch-on portion (P) and thereafter there is a change in the first and second input data due to a movement of the second object (42) in the detection zone (J) along the longitudinal direction (X), or vice versa; or
• both the first (41) and the second object (42) are placed in the detection zone (J) between the first (E1) and the second end (E2) of the switch-on portion (P) and there is a variation in the first and second input data due to a displacement of the first (41) and second objects (42) in the detection zone (J) along the longitudinal direction (X) such that a distance between these objects (41, 42) remains substantially constant during this displacement.

10. Lighting device (1) according to claim 8 or 9, wherein the command data consist of an extension command, in the event that the first input data remain constant due to the static presence in the detection zone (J) of the first object (41) at the first end (E1) of the switch-on portion (P) and the second input data undergo a change due to a displacement in the detection zone (J) of the second object (42) from the second end (E2) of the switch-on portion (P) along the longitudinal direction (X), so that the extension of the switch-on portion (P) is modified by moving its second end (E2) as a result of said displacement of the second object (42), or vice versa.

11. Lighting system (100) comprising a lighting device (1) according to any one of the preceding claims, a driver platform (101) and a control module (102), said driver platform (101) being configured to supply power to the control module (102), such control module (102) comprising the main control unit and being configured to supply power to the detection units (31, 32) and the LED lighting module, to receive first and second input data from the detection units (31, 32) and provide them to the main control unit, and to provide command data from the main control unit to the LED lighting module.
